Europäisches Patentamt

**European Patent Office**

Office européen des brevets

(11) Veröffentlichungsnummer: **0 218 121 B1**

(12) **EUROPÄISCHE PATENTSCHRIFT**

(45) Veröffentlichungstag der Patentschrift: **17.04.91**

(51) Int. Cl.⁵: **H03K 17/62**

(21) Anmeldenummer: **86112709.0**

(22) Anmeldetag: **15.09.86**

(54) **Netzwerk zur Verarbeitung von Daten grosser Bitbreite mit einem Sender und einer Vielzahl von Empfängern.**

(30) Priorität: **25.09.85 DE 3534221**

(43) Veröffentlichungstag der Anmeldung:
**15.04.87 Patentblatt 87/16**

(45) Bekanntmachung des Hinweises auf die
Patenterteilung:
**17.04.91 Patentblatt 91/16**

(84) Benannte Vertragsstaaten:
**AT BE CH DE FR GB IT LI NL SE**

(56) Entgegenhaltungen:
**EP-A- 0 086 434**
**EP-A- 0 144 218**
**DE-B- 2 821 231**
**US-A- 3 648 061**

**IBM TECHNICAL DISCLOSURE BULLETIN,
Band 22, Nr. 8B, Januar 1980, Seiten
3676-3677, New York, US; G.A. MILLER et al.:
"ECL-type register"**

(73) Patentinhaber: **Siemens Aktiengesellschaft
Wittelsbacherplatz 2
W-8000 München 2(DE)**

(72) Erfinder: **Unger, Bernhard, Dr.
Wolfratshauser Strasse 177
W-8000 München 71(DE)**
Erfinder: **Rauschert, Rainer, Dr.
Otto-Bezold-Weg 22
W-8000 München 83(DE)**

Rank Xerox (UK) Business Services

## Beschreibung

Die Erfindung bezieht sich auf ein Netzwerk gemäß dem Oberbegriff des Patentanspruchs 1.

In großen Rechenanlagen haben die zu verarbeitenden Daten recht erhebliche Bitbreiten von beispielsweise 72 Bit, die parallel verarbeitet werden müssen. Mit steigendem Integrationsgrad und wachsender Zahl von Anschlußpins wird es möglich, große Teile oder sogar das gesamte Datenwort in einem LSI-Baustein parallel zu verarbeiten. Intern hat das zur Folge, daß zum Beispiel bei Registern und Multiplexern für ein Datenwort mit der Bitbreite n durch ein Steuersignal n Eingänge von Verknüpfungsgliedern (zum Beispiel Takt-oder Adreßeingänge) angesteuert werden müssen.

Die Anzahl der von einem Sender steuerbaren Eingänge angeschlossener Empfänger, das sogenannte Fanout, ist durch die Belastbarkeit des Senders begrenzt und bei integrierten Bausteinen, die nach dem Masterslice-Verfahren hergestellt werden und einen in eine Mehrzahl von Bereichen aufgeteilten Vorrat von Bauelementen mit vorgegebener Dimensionierung enthalten, ebenfalls fest vorgegeben. Überwiegend beträgt das Fanout n1 der zumeist mit Hilfe einer Zellenbibliothek wählbaren Teilschaltungen (Zellen) mit bipolaren Transistoren in CLM-Schaltungstechnik ungefähr 8. Dieser Wert wird auch den folgenden Ausführungen zugrunde gelegt, wobei natürlich für abweichende Werte die gleichen Überlegungen gelten.

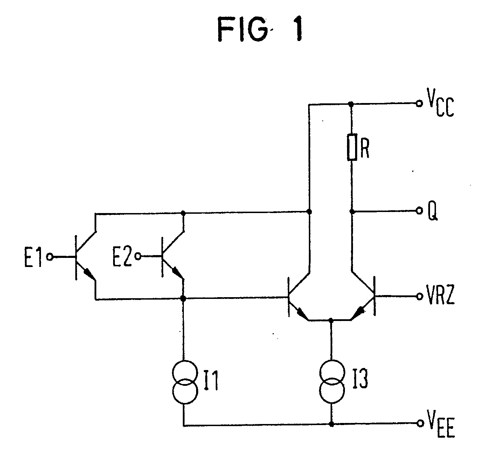

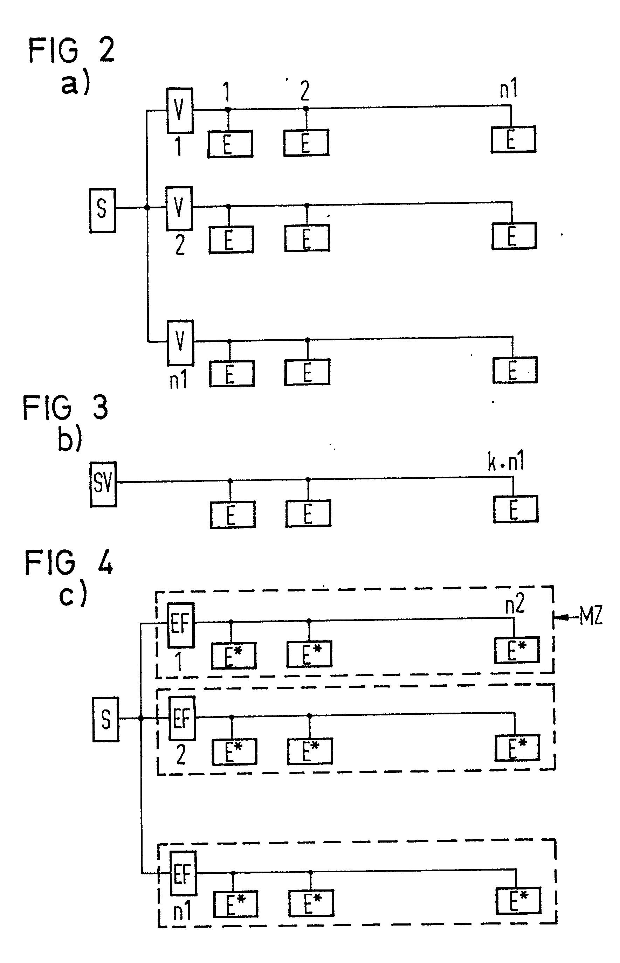

Häufig ist die Anzahl der Empfänger bei großen Bitbreiten n viel größer als das zulässige Fanout nl des Senders. Es ist dann möglich, zusätzliche Verstärker einzusetzen, die von dem Sender gesteuert werden und ihrerseits Jeweils nl Empfänger steuern. Auf diese Weise können also $(nl)^2$ Empfänger versorgt werden. Als Verstärker werden gewöhnlich ODER-Glieder nach FIG 1 verwendet. Ein derartiges Netzwerk weist die in FIG 2 schematisch dargestellte Struktur mit einem Sender S, mit Verstärkern V und mit Empfängern E auf.

Nachteilig bei der Verwendung von Verstärkergliedern ist die Erhöhung der Signallaufzeit, der Verlustleistung und der Zahl der Zellen. Dazu kommt noch daß bei mehr als $(nl)^2$ Empfängern Verstärker in Serie geschaltet werden müssen.

Eine weitere Möglichkeit zur Erhöhung der Zahl der von einem Sender steuerbaren Empfänger besteht in der Vergrößerung des Fanout der als Sender dienenden Schaltungszelle. Die Wahl bleibt dabei auf die doppelte oder dreifache Treiberfähigkeit beschränkt, da die Zahl der Bauelemente, die in Jeder derartigen Schaltungszelle benötigt wird, stark wächst. Zwar verlängert sich die Signallaufzeit zunächst nicht, aber in Fällen, in denen auch die erhöhte Treiberfähigkeit nicht zur Steuerung aller vorhandenen Empfänger ausreicht, müssen wieder zusätzliche Verstärker vorgesehen werden.

Die Struktur eines Netzwerks mit einem Sender SV mit der k-fachen Treiberfähigkeit ist in FIG 3 schematisch dargestellt.

EP-A-O 086 434 zeigt in Figur 2 eine schaltungsanordnung in "$E^2CL$"-Technologie mit zwei 4-Bit-Multiplexern, deren Adresseneingänge über jeweils einen Emitterfolger T1, T2 eine Gruppe von zwei bzw. vier Differenzverstärkern steuern. Dabei handelt es sich jedoch um eine festvorgegebene Bausteinanordnung mit Emitterfolgern kleiner Leistungsfähigkeit.

Der Erfindung liegt die Aufgabe zugrunde, eine Zellenstruktur für Register- oder Multiplexerzellen in CML-Schaltungstechnik mit zwei-oder dreistufiger Serienkopplung zur Verarbeitung von Datenworten mit großen Bitbreiten n anzugeben, bei der von einem Sender eine Vielzahl von Empfängern steuerbar ist, wobei diese Netzwerke ein erheblich kleineres Verlustleistungs-Laufzeitprodukt aufweisen und weniger Bauelementen je Bit benötigen sollen als die vorher diskutierten Netzwerke.

Gemäß der Erfindung wird diese Aufgabe durch die Merkmale im kennzeichnenden Teil des Patentanspruchs 1 gelöst. Spezielle Ausgestaltungen sind den Unteransprüchen zu entnehmen.

Im folgenden wird die Erfindung anhand der FIG 4 bis 6 der Zeichnung näher beschrieben. Es zeigt

FIG 4    das Schema einer erfindungsgemäß ausgebildeten Netzwerkstruktur,

FIG 5    einen 2Bit-Multiplexer in bekannter Ausführung und

FIG 6    eine Schaltungsanordnung gemäß der Erfindung mit mehreren Multiplexern.

Analog zu den Darstellungen nach FIG 2 und FIG 3 zeigt die FIG 4 eine Netzwerkstruktur gemäß der Erfindung, bei der ein Sender S mit dem Fanout n1 und dementsprechend n1 Gruppen MZ mit je n2 Empfängern E* vorgesehen sind. Jede Gruppe MZ von Empfängern E* wird über einen zweistufigen Emitterfolger EF mit erhöter Leistungsfähigkeit angesteuert. Eine solche Empfängergruppe MZ mit dem vorgeschalteten Emitterfolger wird nachstehend als multiple Zelle bezeichnet.

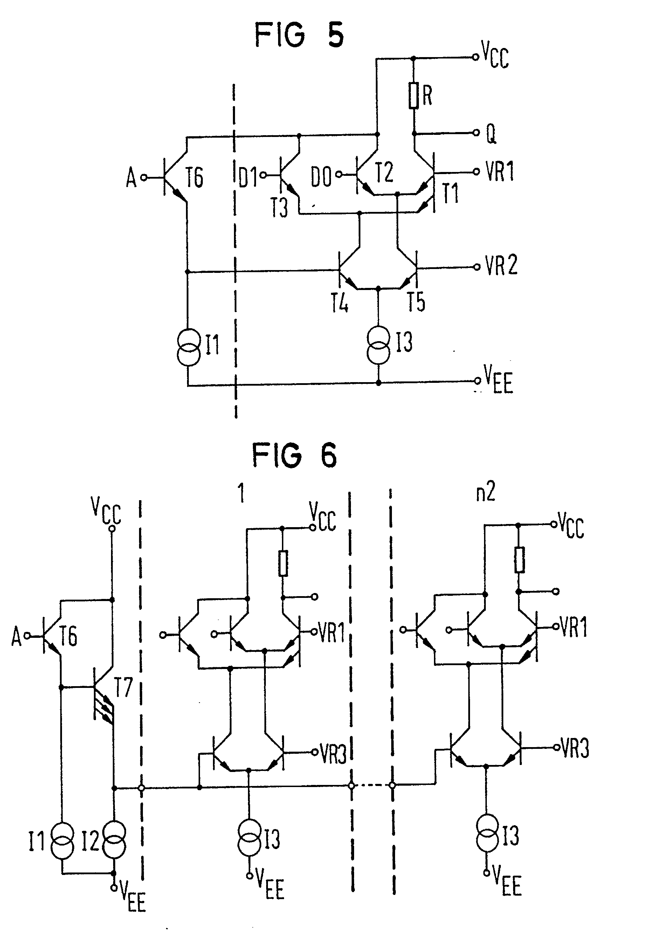

Vor auf die ausführliche Darstellung eines Ausführungsbeispiels einer multiplen Zelle mit 2Bit-Multiplexern in FIG 6 näher eingegangen wird, ist auf die FIG 5 zu verweisen, die eine übliche 2Bit-Multiplexerzelle in CML-Schaltungstechnik mit Serienkopplung zeigt. Die Multiplexerzelle enthält drei Differenzverstärker, wovon die beiden oberen Differenzverstärker der ersten logischen Serienkopplungsebene einen gemeinsamen Doppelemittertransistor T1 aufweisen. Der Kollektor des Transistors T1 ist mit dem Ausgang Q und

2

über einen Kollektorwiderstand R mit dem als Bezugspotential dienenden Anschluß $V_{CC}$ einer Betriebsspannungsquelle verbunden. Die Basis des Transistors T1 liegt auf einem ersten Referenzpotential VR1. Sofern der Bauelementevorrat der Masterslice-Anordnung keine Doppelemittertransistoren enthält, kann der Transistor T1 auch durch zwei einfache Transistoren realisiert werden, deren Kollektoren einerseits und deren Basisanschlüsse andererseits parallel geschaltet sind.

Zusammen mit dem Transistor T1 bildet der Transistor T2, an dessen Basis ein erstes Datenbit D0 anliegt, einen ersten Differenzverstärker. Ein zweiter, durch das zweite Datenbit D1 gesteuerter Differenzverstärker entsteht durch das Zusammenwirken des Transistors T1 mit dem Transistor T3.

Die paarweise miteinander verbundenen Emitter der Transistoren T1, T2 bzw. T1, T3 des ersten bzw. zweiten Differenzverstärkers sind an die Kollektoren von emittergekoppelten Transistoren T4 bzw. T5 eines dritten Differenzverstärkers angeschlossen, der einer zweiten logischen Serienkopplungsebene zugeordnet wird.

Der Schaltzustand des dritten Differenzverstärkers entscheidet, ob dem ersten oder dem zweiten Differenzverstärker der Konstantstrom I3 zugeführt wird, das heißt ob das erste oder zweite Datenbit D0 oder D1 auf den Ausgang Q durchgeschaltet wird. Der Differenzverstärker der zweiten logischen Ebene wird über einen Emitterfolger mit dem Transistor T6 und einer Stromquelle zur Lieferung des Konstantstroms I1 durch ein Adreßbit A gesteuert. Der Emitterfolger verursacht eine Pegelverschiebung der Binärwerte des Adreßbits A derart, daß der Mittelwert der verschobenen Signalpegel dem Referenzpotential VR2 entspricht. Der in FIG 5 rechts von der senkrechten gestrichelten Linie liegende Schaltungsteil des 2Bit-Multiplexers wird im folgenden als Rumpfzelle bezeichnet.

Die FIG 6 zeigt eine multiple 2Bit-Multiplexerzelle MZ gemäß der Erfindung mit insgesamt n2 Rumpfzellen, von denen die erste und letzte dargestellt sind. Ein Vergleich mit FIG 5 läßt ohne weiteres die hinsichtlich des Schaltungsaufbaus gegebene Übereinstimmung mit der anhand der FIG 5 ausführlich beschriebenen Rumpfzelle erkennen. Zur Zeichnungsvereinfachung wurde deshalb auf Bezugszeichen weitgehend verzichtet.

Die Steuereingänge der dritten Differenzverstärker der Rumpfzellen sind parallel geschaltet und mit dem Ausgang einer durch das Adreßbit A gesteuerten Emitterfolgerzelle verbunden. Die Emitterfolgerzelle besteht aus zwei in Serie geschalteten Emitterfolgern, wobei der erste Emitterfolger aus dem Transistor T6 und der Stromquelle für den Konstantstrom I1 mit dem vorher anhand der FIG 5 beschriebenen Emitterfolger identisch ist. Der nachgeschaltete zweite Emitterfolger mit einem Transistor T7 erhöhter Strombelastbarkeit wird mit einem höheren Strom I2 betrieben. Der Transistor T7 kann beispielsweise durch die Parallelschaltung der entsprechenden Anschlüsse von zwei oder drei Transistoren aus dem normalen Bauelementevorrat realisiert werden.

Ein Unterschied zwischen einer Rumpfzelle nach FIG 5 und den Rumpfzellen nach FIG 6 besteht in der Höhe des Referenzpotentials für den dritten Differenzverstärker, der ursprünglich der zweiten Serienkopplungsebene zugeordnet war und nunmehr der dritten Serienkopplungsebene angehört. Bei der Festlegung des Referenzpotentials VR3 der Rumpfzellen nach FIG 6 muß nämlich die doppelte Signalpegelverschiebung der Binärwerte des Adreßbits A durch die zweistufige Emitterfolgerzelle T6, T7 berücksichtigt werden.

Es ist empfehlenswert, unter den für alle bisher behandelten Beispiele gültigen Bedingungen das maximale Fanout der Emitterfolgerzelle nicht über 16 hinaus zu erhöhen, da sonst zu große Laufzeitunterschiede für ansteigende und abfallende Signalflanken auftreten. Auch mit dieser Beschränkung können durch einen Sender mit dem maximalen Fanout n1 = 8 bereits 128 Empfänger versorgt werden.

Die Anwendung der erfindungsgemäßen Maßnahmen ist nicht auf 2Bit-Multiplexer beschränkt, sondern umfaßt alle Schaltungsanordnungen in CML-Schaltungstechnik mit zwei-oder dreistufiger Serienkopplung, bei denen jeweils für eine Vielzahl solcher Schaltungsanordnungen ein gemeinsames Steuersignal zur Steuerung von Differenzverstärkern in der zweiten oder dritten Serienkopplungsebene wirksam werden soll.

Ein typisches Beispiel solcher Schaltungsanordnungen sind Registerstufen (vergl.DE-PS 31 47 547 und DE-PS 28 21 231) für Register zur parallelen Dateneingabe und/oder -Ausgabe oder für Schieberegister. Auch in diesen Fällen werden Rumpfzellen durch Weglassen der Eingangsemitterfolger zur Eingabe der Taktimpulse bei den einzelnen Registerstufen und sodann multiple Zellen aus einer Mehrzahl von Rumpfzellen und einer vorgeschalteten gemeinsamen Emitterfolgerzelle gebildet. Die allgemeine Struktur eines Netzwerks mit einem Sender S und mit n1 multiplen Zellen MZ, die jeweils aus einer Emitterfolgerzelle EF und n2 Rumpfzellen E* als Empfänger bestehen, zeigt die FIG 4, wie bereits erwähnt wurde.

Für die nachfolgende Gegenüberstellung der behandelten Netzwerkstrukturen wird die Netzwerkstruktur nach FIG 2 als Fall a), die Netzwerkstruktur nach FIG 3 als Fall b) und die Netzwerkstruktur nach FIG 4 als Fall c) bezeichnet.

Es wurden Simulationsrechnungen durchgeführt und dabei 2Bit-Multiplexer und folgende Werte zugrundegelegt.

Fanout n1 $\quad$ = 8

Strom I1 $\quad$ = 0,5 mA

Strom I2 $\quad$ = 1,5 mA

Strom I3 $\quad$ = 1,5 mA

Widerstand R $\quad$ = 300 Ohm

Betriesbspannung $V_{EE} - V_{CC}$ = -4,5 V

Im Fall b) beträgt der Differenzverstärkerstrom des Senders $2I3 = 3$ mA.

Die nachstehende Tabelle zeigt für verschiedene Bitbreiten n die maximale Adreßlaufzeit $t_{dA}$, das Verlustleistungs-Laufzeitprodukt $P_v \cdot t_{dA}$ pro Bit und die Anzahl m der Bauelemente pro Bit für die Fälle a), b) und c).

| n | Fall a) | | | Fall b) | | | Fall c) | | |
| | $t_{dA}$ ps | $P_v \cdot t_{dA}$ pJ | m | $t_{dA}$ ps | $P_v \cdot t_{dA}$ pJ | m | $t_{dA}$ ps | $P_v \cdot t_{dA}$ | m |
| --- | --- | --- | --- | --- | --- | --- | --- | --- | --- |
| 8 | 680 | 6,1 | 12 | 580 | 5,7 | 12,3 | 625 | 4,9 | 10 |
| 16 | 1060 | 10,7 | 13 | 680 | 6,4 | 12,1 | 735 | 5,4 | 9,5 |
| 32 | 1110 | 11,2 | 13 | 1035 | 10,6 | 12,7 | 760 | 5,6 | 9,5 |
| 64 | 1210 | 12,3 | 13 | 1060 | 10,7 | 12,7 | 810 | 5,9 | 9,5 |
| 128 | 1590 | 16,3 | 13,1 | 1110 | 11,1 | 12,6 | 910 | 6,7 | 9,5 |
| 256 | 1640 | 16,8 | 13,1 | 1210 | 12,1 | 12,6 | 1290 | 9,5 | 9,6 |
| 512 | 1740 | 17,9 | 13,1 | 1565 | 15,7 | 12,4 | 1340 | 9,9 | 9,6 |

Die Tabelle zeigt eine deutliche Überlegenheit der erfindungsgemäßen Netzwerkstruktur gemäß Fall c) schon für Bitbreiten $n \geq 16$ im Hinblick auf alle drei untersuchten Ergebnisgrößen. Das gilt auch für Bitbreiten $n > 128$, obwohl dann zusätzliche Verstärker erforderlich sind.

**Ansprüche**

1. Netzwerk in CML-Schaltungstechnik zur Verarbeitung von Daten mit großer Bitbreite, mit einem Sender (s) vorgegebener Belastungsfähigkeit n1 und einer Vielzahl n von Empfängern mit Differenzverstärkern in zwei- oder dreistufiger Serienkopplung, wobei die Gesamtzahl n der Empfänger die Belastungsfähigkeit des Senders erheblich übersteigt und in n1 Gruppen mit je n2 Empfängern unterteilt ist, **dadurch gekennzeichnet,** daß die gewöhnlich zur Steuerung des Differenzverstärkers der zweiten oder dritten Serienkopplungsebene in jedem Empfänger vorgesehenen Eingangsemitterfolger (T6) entfallen und durch jeweils für eine Gruppe (MZ) von Emfängern (E*) gemeinsame, zweistufige Emitterfolgerzellen (EF; T6, T7) erhöhter Leistungsfähigkeit ersetzt sind, wobei der Emitterstrom (I2) der zweiten Stufe (T7) mindestens die Größe des Emitterstroms (I3) der jeweiligen Empfänger (E*) aufweist und das Referenzpotential (VR3) der zweiten bzw. dritten Serienkopplungsebene an die Signalpegelverschiebung der zweistufigen Emitterfolgerzellen (EF) angepaßt ist.

2. Netzwerk nach Anspruch 1, **dadurch gekennzeichnet,** daß neben dem Sender (S) mit der Belastungsfähigkeit (n1) zur Lieferung einer * Auswahladresse (A) n > n1 2Bit Multiplexer enthalten sind, deren Adresseneingänge die Empfängereingänge bilden.

3. Netzwerk nach Anspruch 1, **dadurch gekennzeichnet**, daß neben dem Sender (S) mit der Belastungsfähigkeit n1 zur Lieferung von Taktimpulsen n > n1 Registerstufen enthalten sind, deren Takteingänge die Empfängereingänge bilden.

## Claims

1. Network in CML circuit technology for processing large bit width data, with an emitter (S) of predetermined loadability n1 and a multiplicity n of receivers with differential amplifiers in two- or three-stage series coupling, the total number n of receivers exceeding the loadability of the transmitter considerably and being subdivided into n1 groups each having n2 receivers, characterised in that the input emitter followers (T6) usually provided in each receiver for controlling the differential amplifier of the second or third series coupling level are omitted and replaced by two-stage emitter follower cells (EF; T6, T7) of increased power which are common in each case to a group (MZ) of receivers (E*), the emitter current (I2) of the second stage (T7) is at least the size of the emitter current (I3) of the respective receivers (E*) and the reference potential (VR3) of the second or third series coupling level is matched to the signal level displacement of the two-stage emitter follower cells (EF).

2. Network according to Claim 1, characterised in that, in addition to the transmitter (S) having the loadability (n1) for supplying a selection address (A) n > n1, there are 2-bit multiplexers, the address inputs of which form the receiver inputs.

3. Network according to Claim 1, characterised in that, in addition to the transmitter (S) having the loadability n1 for supplying clock pulses n > n1, there are register stages, the clock inputs of which form the receiver inputs.

## Revendications

1. Réseau réalisé selon la technique des circuits CML pour le traitement de données possédant une grande largeur en bits, comportant un émetteur (S) possédant une capacité de charge prédéterminée n1 et une multiplicité de n récepteurs comportant des amplificateurs différentiels couplés selon un couplage série à deux ou trois étages, le nombre total n des récepteurs dépassant fortement la capacité de charge de l'émetteur et étant réparti en n1 groupes contenant chacun n2 récepteurs, caractérisé par le fait que les montages émetteurs-suiveurs d'entrée (6), qui sont prévus habituellement pour la commande de l'amplificateur différentiel du second ou du troisième plan de couplage série dans chaque récepteur, sont supprimés et remplacés par des cellules respectives d'émetteurs-suiveurs (EF;T6,T7) à deux étages, communs à un groupe (MZ) de récepteurs (E*) et possédant une puissance accrue, le courant d'émetteur (I2) du second étage (T7) possédant au moins la valeur du courant d'émetteur (I3) du récepteur respectif (E*), tandis que le potentiel de référence (VR3) du second ou du troisième plan de couplage série est adapté au décalage du niveau des signaux des cellules d'émetteurs-suiveurs (ET) à deux étages.

2. Réseau suivant la revendication 1, caractérisé par le fait qu'en plus de l'émetteur (S) possédant la capacité de charge (n1), il est prévu, pour la délivrance d'une adresse de sélection (A), n > n1 multiplexeurs à 2 bits, dont les entrées d'adresses forment les entrées du récepteur.

3. Réseau suivant la revendication 1, caractérisé par le fait qu'en plus de l'émetteur (S) possédant la capacité de charge (n1), il est prévu, pour la délivrance d'impulsions de cadence, n > n1 étages de registres, dont les entrées de cadence forment les entrées du récepteur.

# FIG 1

# FIG 2
## a)

# FIG 3
## b)

# FIG 4
## c)

# FIG 5

# FIG 6